# EUROPÄISCHE PATENTANMELDUNG

(11) **EP 0 545 859 A1**
(43) Veröffentlichungstag der Anmeldung: **09.06.1993**
(21) Anmeldenummer: 92810897.6
(22) Anmeldetag: 18.11.1992
(51) Int. Cl.: G03F 7/039, C08G 63/18

(54) **Strahlungsempfindliche Zusammensetzungen**

(30) Priorität: 26.11.1991 CH 3462/91
(71) Anmelder: CIBA-GEIGY AG, CH-4002 Basel (CH)
(72) Erfinder: Steinmann, Alfred, Dr., CH-1724 Praroman (CH)

(57) **Zusammenfassung**

Strahlungsempfindliche Zusammensetzungen enthaltend
(a) einen Polyester enthaltend wiederkehrende Struktureinheiten der Formel (I) 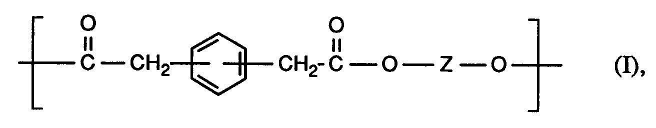 worin Z für einen Rest der Formeln (IIa)-(IIh) steht 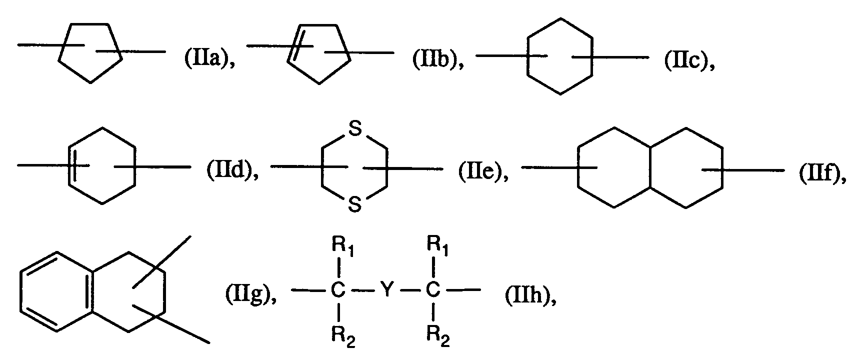 worin Y für eine direkte Bindung, C₁-C₂₀-Alkylen, Phenylen, -CH₂-C₆H₄-CH₂-, Cyclopentylen oder Cyclohexylen steht und R₁ und R₂ unabhängig voneinander Wasserstoff, Methyl oder Ethyl bedeuten, mit der Massgabe, dass R₁ und R₂ nicht gleichzeitig Wasserstoff sind, und
(b) eine unter Einwirkung von aktinischer Strahlung säurebildende Substanz,

bilden eine hochempfindliche Positiv-Photoresist-Formulierung mit hohem Auflösungsvermögen, die für die DUV-Lithographie und insbesondere zur Herstellung von integrierten Schaltkreisen geeignet ist.

## Beschreibung

Gegenstand der vorliegenden Erfindung sind photoempfindliche Zusammensetzungen enthaltend einen Polyester, abgeleitet von Phenylendiessigsäurederivaten und sekundären oder tertiären Diolen, und eine unter Einwirkung von aktinischer Strahlung säurebildende Substanz, sowie die Verwendung dieser Zusammensetzungen als Photoresists in der DUV-Lithographie.

Photoresistzusammensetzungen auf Basis von Polycarbonaten und Oniumsalzen, die für die Lithographie im tiefen UV-Bereich (DUV, Wellenlängen von ca. 200 nm bis ca. 300 nm) geeignet sind, sind beispielsweise aus Polymer Journal 19, S. 31-49 ( 1987) bekannt. Die Synthese der dort beschriebenen Polycarbonate durch Polykondensation von Bis(p-nitrophenyl)carbonaten und Diolen unter Phasen-Transfer-Katalyse ist jedoch relativ aufwendig. Ausserdem weisen die so hergestellten Polymeren relativ niedrige Molekulargewichte auf. Nach dem Belichten mit relativ hohen Strahlungsdosen erfolgt die Entwicklung dieser Photoresists durch Erhitzen des belichteten Films auf 80 °C. Zur vollständigen Entfernung der monomeren oder oligomeren Spaltprodukte ist eine anschliessende Vakuumbehandlung oder Eintauchen in organische Lösungsmittel erforderlich.

Die aus dem US-Patent 4,663,269 bekannten DUV-Photoresist-Zusammensetzungen aus Oniumsalzen und Polycarbonaten liefern hochaufgelöste Bilder, benötigen jedoch relativ hohe Belichtungsenergien und ebenfalls organische Lösungsmittel für die Entwicklung.

In Polym. Mater. Sci. Eng. 60, S. 170-173 (1989) werden strahlungsempfindliche Zusammensetzungen beschrieben, enthaltend einen Polyester auf der Basis von Terephthalsäure- bzw. Isophthalsäurederivaten und ein Oniumsalz, die zur Herstellung von strukturierten Positiv-Bildern verwendet werden können. Die hier offenbarten Polyester, die durch die relativ aufwendige Polykondensation von Dibromiden und Bisphenolen unter Phasen-Transfer-Katalyse hergestellt werden, absorbieren selbst im DUV-Bereich, was zu einer niedrigen Empfindlichkeit der Gemische in diesem Wellenlängenbereich führt.

Es wurde nun gefunden, dass Polyester auf der Basis von Phenylendiessigsäurederivaten, die sich durch unproblematische Lösungspolykondensation herstellen lassen, eine hohe Transparenz im DUV aufweisen und zusammen mit einem strahlungsempfindlichen Säurebildner eine hochempfindliche Resistformulierung darstellen, die zur Auflösung von Strukturen im Submikronbereich geeignet ist.

Gegenstand der vorliegenden Erfindung ist eine strahlungsempfindliche Zusammensetzung enthaltend
(a) einen Polyester enthaltend wiederkehrende Struktureinheiten der Formel (I) 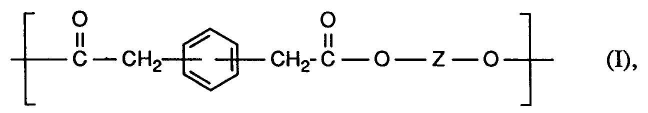 worin Z für einen Rest der Formeln (IIa)-(IIh) steht 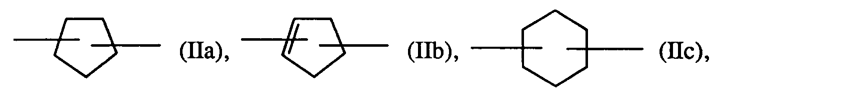 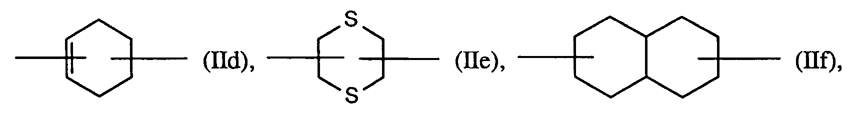 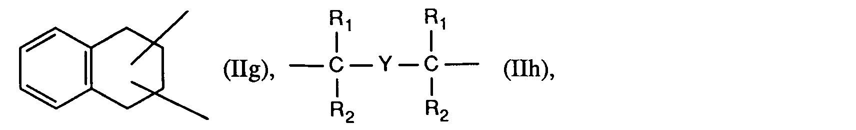 worin Y für eine direkte Bindung, C₁-C₂₀-Alkylen, Phenylen, -CH₂-C₆H₄-CH₂-, Cyclopentylen oder Cyclohexylen steht und R₁ und R₂ unabhängig voneinander Wasserstoff, Methyl oder Ethyl bedeuten, mit der Massgabe, dass R₁ und R₂ nicht gleichzeitig Wasserstoff sind, und
(b) eine unter Einwirkung von aktinischer Strahlung säurebildende Substanz.

Die Polyester der Formel (I) sind abgeleitet von Derivaten der 1,2-Phenylendiessigsäure und vorzugsweise der 1,3- oder 1,4-Phenylendiessigsäure. Besonders bevorzugt sind Polyester, die sich von Derivaten der 1,4-Phenylendiessigsäure ableiten.

Bedeutet Z in der Formel (I) Cyclopentylen, so handelt es sich vorzugsweise um 1,3-Cyclopentylen.

Steht Z in der Formel (I) für Cyclopentenylen, so handelt es sich vorzugsweise um 1,3-Cyclopent-4-enylen.

Ist Z in der Formel (I) Cyclohexylen, so handelt es sich dabei um 1,2-Cyclohexylen, 1,3-Cyclohexylen oder insbesondere um 1,4-Cyclohexylen.

Bedeutet Z in der Formel (I) Cyclohexenylen, so handelt es sich vorzugsweise um 1,4-Cyclohex-5-enylen.

Bedeutet Y in der Formel (IIh) C₁-C₂₀-Alkylen, so kann es sich dabei um verzweigte oder vorzugsweise um unverzweigte Reste handeln. Beispiele für Alkylenreste sind Methylen, Ethylen, Propylen, Butylen, Pentylen, Hexylen, Decylen und Dodecylen.

Y als Phenylen ist vorzugsweise 1,4-Phenylen.

Bedeutet Y in der Formel (IIh) Cyclopentylen, so handelt es sich vorzugsweise um 1,3-Cyclopentylen.

Steht Y in der Formel (IIh) für Cyclohexylen, so handelt es sich dabei insbesondere um 1,4-Cyclohexylen.

Bevorzugt werden erfindungsgemässe Zusammensetzungen verwendet, enthaltend als Komponente (a) einen Polyester der Formel (I), worin Z für eine Gruppe der Formel (IIh) steht.

Besonders bevorzugt sind Zusammensetzungen, enthaltend als Komponente (a) einen Polyester der Formel (I), worin Z für eine Gruppe der Formel (IIh) und Y für 1,4-Phenylen steht.

Insbesondere bevorzugt sind Zusammensetzungen, enthaltend als Komponente (a) einen Polyester der Formel (I), worin Z für eine Gruppe der Formel (IIh), Y für 1,4-Phenylen, R₁ für Wasserstoff und R₂ für Methyl steht.

Eine weitere bevorzugte Zusammensetzung enthält als Komponente (a) einen Polyester der Formel (I), worin Z für eine Gruppe der Formel (IIh), Y für C₁-C₂₀-Alkylen, R₁ für Wasserstoff und R₂ für Methyl steht.

Besonders bevorzugt sind Zusammensetzungen, die als Komponente (a) einen Polyester der Formel (I) enthalten, worin Z für 1,4-Cyclohexylen steht.

Ganz besonders bevorzugt sind Zusammensetzungen, die als Komponente (a) einen Polyester der Formel (I) enthalten, worin Z für den zweiwertigen Rest des 1,4-Dihydroxy- 1,2,3,4-tetrahydronaphthalins nach dem Entfemen der Hydroxygruppen steht.

Die Polyester der Formel (I) sind z.T. bekannt, beispielsweise aus der JP-A 60/164425, und können nach an sich bekannten Methoden hergestellt werden, beispielsweise indem man ein Phenylendiessigsäurederivat, wie z.B. Phenylendiessigsäuredi-p-nitrophenolat, Phenylendiessigsäuredibromid oder vorzugsweise Phenylendiessigsäuredichlorid, mit einem Diol der Formel (III)

HO―Z―OH (III),

worin Z die gleiche Bedeutung wie in Formel (I) hat, in einem aprotisch polaren Lösungsmittel in Gegenwart von Basen polykondensiert. Durch eine solche homogene Lösungspolykondensation lassen sich Polyester mit hohem Molekulargewicht herstellen.

Die Dihydroxyverbindungen der Formel (III) sind bekannt und zum Teil im Handel erhältlich. Beispiele für geeignete Verbindungen der Formel (III) sind 1,2- oder 1,3-Dihydroxycyclopentan, 1,2-, 1,3- oder 1,4-Dihydroxycyclohexan, 2,5-Dihydroxy-1,4-dithian, 1,5-Dihydroxydecahydronaphthalin, 1,4-Dihydroxy- 1,2,3,4-tetrahydronaphthalin, 2,5-Dihydroxyhexan, 2,6-Dihydroxyheptan, 2,7-Dihydroxyoctan, 1,2-Bis(1-hydroxyethyl)benzol, 1,3-Bis(1-hydroxyethyl)benzol, 1,4-Bis(1-hydroxyethyl)benzol, 1,2-Bis(1-hydroxyethyl)cyclohexan, 1,3-Bis(1 -hydroxyethyl)cyclohexan, 1,4-Bis(1 -hydroxyethyl)cyclohexan, 1,4-Bis(2-hydroxypropyl)benzol und 1,4-Bis(2-hydroxypropyl)cyclohexan.

Als strahlungsempfindliche Komponenten b), die bei Lichteinwirkung Säure bilden bzw. abspalten, sind eine grosse Anzahl von Verbindungen bekannt. Dazu zählen beispielsweise Diazoniumsalze, wie sie in der Diazotypie verwendet werden, o-Chinondiazide, wie sie in bekannten positiv arbeitenden Kopiermassen verwendet werden, oder auch Halogenverbindungen, die bei Bestrahlung Halogenwasserstoffsäure bilden. Verbindungen dieser Art sind beispielsweise in den US-PS 3,515,552, 3,536,489 oder 3,779,778, sowie in den DE-OS 2,718,259, 2,243,621 oder 2,610,842 beschrieben.

Als strahlungsempfindliche Komponenten b) der erfindungsgemässen Zusammensetzungen eignen sich vor allem kationische Photoinitiatoren aus der Gruppe der Iodonium- oder Sulfoniumsalze. Solche Verbindungen sind beispielsweise in "UV-Curing, Science and Technology" (Editor. S.P. Pappas, Technology Marketing Corp., 642 Westover Road, Stanford, Connecticut, USA) beschrieben.

Ferner können Sulfoxoniumsalze als strahlungsempfindliche Verbindungen verwendet werden. Solche Salze sind beispielsweise in der EP-PS 35,969 oder in der EP-A 44,274 bzw. 54,509 beschrieben. Insbesondere zu erwähnen sind aliphatische Sulfoxoniumsalze, die im tiefen UV-Bereich absorbieren.

Es lassen sich auch Verbindungen einsetzen, die bei Bestrahlung mit aktinischem Licht Sulfonsäuren freisetzen. Solche Verbindungen sind an sich bekannt und beispielsweise in der GB-A 2,120,263, den EP-A 84,515; 37,512 oder 58,638 bzw. in den US-PS 4,258,121 oder 4,371,605 beschrieben.

Werden als strahlungsempfindliche säureabspaltende Komponenten b) Salze eingesetzt, so sind diese vorzugsweise in organischen Lösungsmitteln löslich. Besonders bevorzugt handelt es sich bei diesen Produkten um Salze von komplexen Säuren, beispielsweise von Tetrafluorborsäure, Hexafluorphosphorsäure, Hexafluorarsensäure oder Hexafluorantimonsäure.

Vorzugsweise wird als in den erfindungsgemässen Zusammensetzungen als Komponente (b) ein Iodonium-, Sulfonium- oder Sulfoxoniumsalz eingesetzt.

Besonders bevorzugt als Komponente (b) sind Triphenylsulfoniumtriflat und Triphenylsulfoniumhexafluoroantimonat.

Vorzugsweisë enthalten die erfindüngsgemässen Zusammensetzungen, bezogen auf die Gesamtmenge der Komponenten (a) und (b), 85-99 Gew.-%, insbesondere 92-98 Gew.-%, der Komponente (a) und 1-15 Gew.-%, insbesondere 2-8 Gew.-%, der Komponente (b).

Den erfindungsgemässen strahlungsempfindlichen Gemischen können gegebenenfalls auch Bindemittel (c) zugesetzt werden, was besonders zweckmässig ist, wenn es sich bei den lichtempfindichen Zusammensetzungen um flüssige öder niedrigviskose Gemische handelt.

Die Menge des Bindemittels (c) kann 30-90 Gew.%, vorzugsweise 60-90 Gew.%, betragen, bezogen auf die gesamte Menge an Komponenten a), b) und c).

Die Wahl des Bindemittels erfolgt je nach dem Anwendungsgebiet und den hierfür geforderten Eigenschaften, wie Entwickelbarkeit in wässrigen und wässrig-alkalischen Lösungsmittelsystemen oder Adhäsion auf Substraten.

Geeignete Bindemittel c) sind beispielsweise Novolake, die sich von einem Aldehyd, vorzugsweise Formaldehyd, Acetaldehyd oder Furfuraldehyd, besonders jedoch von Formaldehyd, und einem Phenol ableiten. Die phenolische Komponente dieser Bindemittel ist vorzugsweise Phenol selbst, oder auch halogeniertes Phenol, beispielsweise substituiert mit ein bis zwei Chloratomen, vorzugsweise p-Chlorphenol, oder sie ist ein durch ein bis zwei C₁-C₉-Alkylgrupppen substituiertes Phenol, beispielsweise o- m- oder p-Kresol, ein Xylenol, p-tert.Butylphenol oder p-Nonylphenol. Es kann sich bei der Phenolkomponente der bevorzugten Novolake aber auch um p-Phenylphenol, Resorcin, Bis-(4-hydroxyphenyl)-methan oder 2,2-Bis-(4-hydroxyphenyl)-propan handeln.

Ein Teil der phenolischen Hydroxygruppen dieser Novolake kann gegebenenfalls durch Umsetzung mit Chloressigsäure, Isocyanaten, Epoxiden oder Carbonsäureanhydriden modifiziert sei.

Weitere geeignete Bindemittel sind beispielsweise Copolymere von Maleinsäureanhydrid mit Styrol oder Vinylethern oder 1-Alkenen. Ebenfalls als Bindemittel einsetzen lassen sich:
Homo- und copolymere Acrylate und Methacrylate, z.B. Copolymere aus Methylmethacrylat/Aethylacrylat/Methacrylsäure, Poly(methacrylsäurealkylester) oder Poly(acrylsäurealkylester), wobei Alkyl = C₁-C₂₀ ist.

Vorzugsweise verwendet man als Bindemittel eine alkalilösliche Substanz, beispielsweise einen Novolak (gegebenenfalls modifiziert, wie oben beschrieben), Copolymere von Maleinsäureanhydrid mit Styrol oder Vinylethern oder 1-Alkenen, sowie Copolymere von Estern der Acrylsäure oder der Methacrylsäure mit ethylenisch ungesättigten Säuren, beispielsweise Methacrylsäure oder Acrylsäure.

Diesen alkalilöslichen Bindemitteln können gegebenenfalls noch weitere Zusatzharze beigegeben werden, wie bei den Positiv-Systemen auf Diazoketon-Basis üblich. Zu diesen Zusatzharzen zählen beispielsweise Vinylpolymerisate, wie Polyvinylacetat, Polyacrylate, Polyvinylether oder Polyvinylpyrrolidone. Im allgemeinen werden jedoch nicht mehr als 20 Gew.%, bezogen auf die Menge an alkalilöslichem Bindemittel, von diesen Zusatzharzen zugefügt.

Die erfindungsgemässen Zusammensetzungen können weitere übliche Zusatzstoffe enthalten, wie z.B. Stabilisatoren, Pigmente, Farbstoffe, Füllstoffe, Haftvermittler, Verlaufmittel, Netzmittel und Weichmacher. Ferner können die Zusammensetzungen zur Applikation in geeigneten Lösungsmitteln gelöst werden.

Die erfindungsgemässen Zusammensetzungen eignen sich hervorragend als Beschichtungsmittel für Substrate aller Art, z.B. Holz, Textilien, Papier, Keramik, Glas, Kunststoffe, wie Polyester, Polyethylenterephthalat, Polyolefine oder Celluloseacetat, insbesondere in Form von Filmen, sowie Metalle, wie Al, Cu, Ni, Fe, Zn, Mg oder Co, und GaAs, Si oder SiO₂, bei denen durch bildmässiges Belichten eine Abbildung aufgebracht werden soll.

Die Herstellung der beschichteten Substrate kann z.B. erfolgen, indem man eine Lösung oder Suspension der Zusammensetzung herstellt.

Die Wahl des Lösungsmittels und die Konzentration richtet sich hauptsächlich nach der Art der Zusammensetzung und nach dem Beschichtungsverfahren. Die Lösung wird mittels bekannten Beschichtungsverfahren auf ein Substrat gleichförmig aufgebracht, z.B durch Schleudern, Tauchen, Rakelbeschichtung, Vorhanggiessverfahren, Aufpinseln, Sprühen, speziell durch elektrostatisches Sprühen und Reverse-Rollbeschichtung. Es ist auch möglich, die lichtempfindliche Schicht auf einen temporären, flexiblen Träger zu bringen, und dann durch Schichtübertragung via Laminierung das endgültige Substrat, z.B. eine kupferkaschierte Leiterplatte, zu beschichten.

Die Auftragsmenge (Schichtdicke) und Art des Substrates (Schichtträger) sind abhängig vom gewünschten Applikationsgebiet. Besonders vorteilhaft ist es, dass die erfindungsgemässen Zusammensetzungen in weiter variablen Schichtdicken eingesetzt werden können. Dieser Schichtdickenbereich umfasst Werte von ca. 0,5 µm bis mehr als 100 µm. Mit konventionellen Positiv-Systemen auf Naphthochinondiazid-Basis sind Schichtdicken vorzugsweise kleiner als 10 µm verwendbar.

Mögliche Einsatzgebiete der erfindungsgemässen Zusammensetzungen sind die Verwendung als Photoresists für die Elektronik (Galvanoresist, Aetzresist, Lötstoppresist), die Herstellung von Druckplatten, wie Offsetdruckplatten oder Siebdruckformen, der Einsatz beim Formteilätzen oder insbesondere der Einsatz als Photoresist bei der Herstellung integrierter Schaltkreise.

Aufgrund des sehr hohen Auflösungsvermögens (Submikronbereich) sind die erfindungsgemässen Photoresistzusammensetzungen besonders zur Herstellung von Mikrochips geeignet. Die Verwendung der erfindungsgemässen Zusammensetzungen als Photoresist zur Herstellung von integrierten Schaltkreisen bildet daher einen weiteren Erfindungsgegenstand.

Gemäss den vielfältigen Verwendungsmöglichkeiten können die möglichen Schichtträger und die Verarbeitungsbedingungen sehr unterschiedlich sein.

Für photographische Informationsaufzeichnung dienen z.B. Folien aus Polyester, Celluloseacetat oder mit Kunststoff beschichtete Papiere; für Offsetdruckformen speziell behandeltes Aluminium, für die Herstellung gedruckter Schaltungen kupferkaschierte Laminate und für die Herstellung von integrierten Schaltkreisen Siliziumwafer. Die Schichtdicken für photographische Materialien und Offsetdruckformen betragen ca. 0,5 µm bis 10 µm; für gedruckte Schaltungen 1 bis ca. 100 µm.

Nach dem Beschichten wird das Lösungsmittel in der Regel durch Trocknen entfernt, und es resultiert eine Schicht des Photoresists auf dem Träger.

Nach der in üblicher Weise erfolgten bildmässigen Belichtung des Materials werden die belichteten Stellen des Photolackes durch Herauslösen in einem Entwickler entfernt.

Die Wahl des jeweiligen Entwicklers richtet sich nach der Art des Photolackes, insbesondere nach der Natur des verwendeten Bindemittels oder der entstehenden Photolyseprodukte. Der Entwickler kann wässrige Lösungen von Basen umfassen, denen gegebenenfalls organische Lösungsmittel oder deren Mischungen zugesetzt wurden.

Besonders bevorzugt als Entwickler werden wässrig alkalische Lösungen, wie sie auch für die Entwicklung von Naphthochinondiazidschichten eingesetzt werden. Dazu zählen insbesondere wässrige Lösungen von Alkalimetallsilikaten, -phosphaten, -hydroxiden und -carbonaten. Diesen Lösungen können gegebenenfalls noch kleinere Mengen an Netzmitteln und/oder organischen Lösungsmitteln zugesetzt sein.

Typische organische Lösungsmittel, die den Entwicklerflüssigkeiten zugesetzt werden können, sind beispielsweise Cyclohexanon, 2-Ethoxyethanol, Toluol, Aceton, sowie Mischungen zweier oder mehrerer dieser Lösungsmittel.

Der Begriff 'bildmässige' Belichtung beinhaltet sowohl die Belichtung durch eine Photomaske, die ein vorbestimmtes Muster enthält, beispielsweise ein Diapositiv, die Belichtung durch einen Laserstrahl, der beispielsweise computergesteuert über die Oberfläche des beschichteten Substrates bewegt wird, und auf diese Weise ein Bild erzeugt, die Bestrahlung mit computergesteuerten Elektronenstrahlen, sowie die Bestrahlung mit Röntgenstrahlen durch eine entsprechende Maske.

Als Strahlungsquellen können im Prinzip sämtliche Lampen verwendet werden, die Strahlung im DUV-Bereich (ca. 200-300 nm) emittieren. Es sind sowohl Punktlichtquellen als auch flächenförmige Strahler (Lampenteppiche) geeignet. Beispiele sind: Kohlelichtbogenlampen, Xenon-Lichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen, photographische Flutlichtlampen, Elektronenstrahlen und Röntgenstrahlen. Der Abstand zwischen Lampe und erfindungsgemässem Bildmaterial kann je nach Anwendungszweck und Lampentyp bzw. -stärke variieren, z.B. zwischen 2 cm bis 150 cm. Speziell geeignet sind Laserlichtquellen, z.B. Argonionenlaser oder Kryptonionenlaser. Mit Laserlicht kann der Resist auch ohne Maske belichtet werden, indem der gesteuerte Laser-Strahl direkt auf der Resist-Schicht schreibt. Hier ist die hohe Empfindlichkeit der erfindungsgemässen Materialien sehr vorteilhaft, die hohe Schreibgeschwindigkeiten bei relativ niedrigen Intensitäten erlaubt. Nach dieser Methode können gedruckte Schaltungen in der Elektronikindustrie, lithographische Offsetdruckplatten oder Reliefdruckplatten sowie photographische Bildaufzeichnungsmaterialien hergestellt werden. Die hohe Empfindlichkeit der Resists ist auch für die Belichtung mittels DUV-Stepper von Vorteil, da sehr kurze Belichtungszeiten erwünscht sind.

Die Erfindung betrifft daher auch die unter Verwendung besagter Zusammensetzungen hergestellten Druckformen, gedruckten Schaltungen, integrierten Schaltkreise oder silberlosen photographischen Filme.

### I. Synthese der Polyester (Komponente (a))

### I.1. Polyester aus 1,4-Phenylendiessigsäuredichlorid und 1,4-Dihydroxy-1,2,3,4-tetrahydronaphthalin

Zu einer Lösung von 41,2 g (0,251 mol) 1,4-Dihydroxy- 1,2,3,4-tetrahydronaphthalin (hergestellt gemäss US-Patent 3,534,109) und 58 g (0,251 mol) Phenylendiessigsäuredichlorid (hergestellt gemäss J. Pol. Sci., Part A-1, 7, S. 3393-3405 (1969)) in 350 ml Methylenchlorid wird eine Lösung von 41,6 g (0,527 mol) Pyridin in 50 ml Methylenchlorid bei 0-5 °C zugetropft. Das Reaktionsgemisch wird über Nacht bei Raumtemperatur gerührt. Die viskose Lösung wird auf Methanol/Wasser (5:1) getropft, wobei eine klebrige Masse ausfällt. Der Niederschlag wird in Tetrahydrofuran gelöst und erneut in Methanol/Wasser (5:1) ausgefällt. Das so erhaltene Polymer wird abgetrennt und im Hochvakuum getrocknet.
Ausbeute: 56 g (69 %)

Elementaranalyse:
- Ber.:: C: 74,52 H: 5,63 Cl: 0,0
- Gef.:: C: 73,68 H: 5,57 Cl: 0,0

Das durch Gelpermeationschromatographie bestimmte Molekulargewicht beträgt:
Mₙ = 9000
M_{w} = 26000
M_{w}/Mₙ = 2,9

### I.2. Polyester aus Phenylendiessigsäuredichlorid und 1,4-Dihydroxycyclohexan

5,026 g (43,2 mmol) 1,4-Dihydroxycyclohexan und 10 g (43,2 mmol) Phenylendiessigsäuredichlorid werden unter Argon in 80 ml Methylenchlorid vorgelegt und auf 0 °C abgekühlt. Unter Eiskühlung wird eine Lösung von 7,19 g (90,9 mmol) Pyridin in 20 ml Methylenchlorid während 30 min zugetropft. Nach Erwärmen auf Raumtemperatur wird das Reaktionsgemisch noch 15 h gerührt. Die Lösung wird filtriert und auf Methanol/Wasser (5:1) getropft, wobei das Polymer ausfällt. Das Rohprodukt wird anschliessend in 200 ml Methylenchlorid gelöst. Die Lösung wird filtriert, und das Polymer wird in 1,51 Hexan ausgefällt und anschliessend im Hochvakuum getrocknet.
Ausbeute: 10 g (85 %)

Elementaranalyse:
- Ber.:: C: 70,06 H: 6,61 Cl: 0,0
- Gef.:: C: 69,43 H: 6,72 Cl: 0,0

Das durch Gelpermeationschromatographie bestimmte Molekulargewicht beträgt:
Mₙ = 11000
M_{w} = 24000
M_{w}/Mₙ = 2,2

### II. Applikationsbeispiele

### II.1. Positiv-Resist

2,5 g des in Beispiel I.1. hergestellten Polyesters und 125 mg Triphenylsulfoniumtriflat werden in 12 g Cyclopentanon gelöst. Die Lösung wird durch ein 0,5 Mikron-Filter filiert und auf eine Siliziumscheibe aufgetragen. Durch Schleuderbeschichtung (Siliziumwafer) mit 5500 U/min während 20 Sekunden wird ein homogener Film auf der Siliziumscheibe erzeugt. Anschliessend wird der Film 2 Minuten lang bei 100 °C getrocknet. Der so erhaltene Resistfilm hat eine Schichtdicke von 1,25 µm. Der Resistfilm wird durch eine Quarzmaske im Vakuumkontaktverfahren mit UV-Strahlung der Wellenlänge 254 nm belichtet. Dabei wird eine Dosis von 8-11 mJ/cm² benötigt.
Nach der Belichtung wird der Film 90 Sekunden lang auf einer Heizplatte erwärmt, die auf 80 °C aufgeheizt ist, und anschliessend in einem wässrig alkalischen Entwicklerbad (Selectiplast PD 2007 der Firma Merck) während 60 Sekunden entwickelt. Dabei werden die belichteten Zonen herausgelöst (Positiv-Resist). Der Resistfilm wird mit deionisiertem Wasser gespült und bei 90 °C getrocknet.
Analysen im Rasterelektronenmikroskop zeigen senkrechte Kanten und voll aufgelöste Halbmikronstrukturen.

### II.2. Positiv-Resist

10 g des in Beispiel I.2. hergestellten Polyesters und 0,5 g Triphenylsulfoniumhexafluoroantimonat werden in 60 g Cyclopentanon gelöst. Die Lösung wird durch ein 0,5 Mikron-Filter filtriert und auf eine Siliziumscheibe aufgetragen. Durch Schleuderbesichtung (Siliziumwafer) mit 4000 U/min während 20 Sekunden wird ein homogener Film auf der Siliziumscheibe erzeugt. Anschliessend wird der Film 2 Minuten lang bei 90 °C getrocknet. Der so erhaltene Resistfilm hat eine Schichtdicke von 1,0 µm. Der Resistfilm wird durch eine Quarzmaske im Vakuumkontaktverfahren mit UV-Strahlung der Wellenlänge 254 nm belichtet. Dabei wird eine Dosis von 7-8 mJ/cm² benötigt.
Nach der Belichtung wird der Film 90 Sekunden lang auf einer Heizplatte erwärmt, die auf 70 °C aufgeheizt ist, und anschliessend in einem wässrig alkalischen Entwicklerbad (Selectiplast PD 2007 der Firma Merck) während 60 Sekunden entwickelt. Dabei werden die belichteten Zonen herausgelöst (Positiv-Resist). Der Resistfilm wird mit deionisiertem Wasser gespült und bei 90 °C getrocknet.
Analysen im Rasterelektronenmikroskop zeigen klar aufgelöste Submikronstrukturen.

## Patentansprüche

1. Strahlungsempfindliche Zusammensetzung enthaltend
(a) einen Polyester enthaltend wiederkehrende Struktureinheiten der Formel (I) 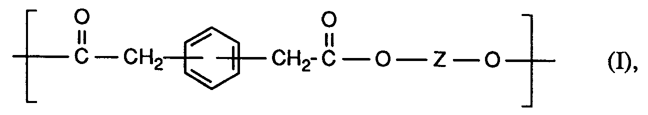 worin Z für einen Rest der Formeln (IIa)-(IIh) steht 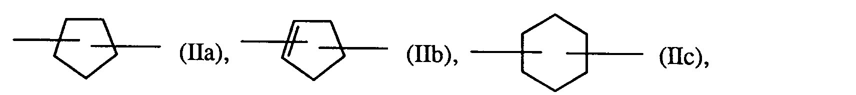 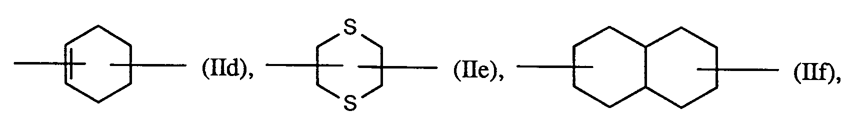 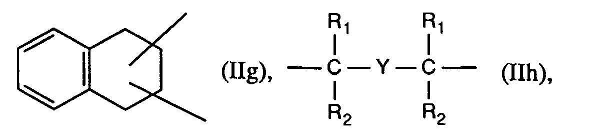 worin Y für eine direkte Bindung, C₁-C₂₀-Alkylen, Phenylen, -CH₂-C₆H₄-CH₂-, Cyclopentylen oder Cyclohexylen steht und R₁ und R₂ unabhängig voneinander Wasserstoff, Methyl oder Ethyl bedeuten, mit der Massgabe, dass R₁ und R₂ nicht gleichzeitig Wasserstoff sind, und
(b) eine unter Einwirkung von aktinischer Strahlung säurebildende Substanz.

2. Zusammensetzung gemäss Anspruch 1, enthaltend als Komponente (a) einen Polyester der Formel (I), worin Z für eine Gruppe der Formel (IIh) steht.

3. Zusammensetzung gemäss Anspruch 2, worin Y in der Formel (IIh) für 1,4-Phenylen steht.

4. Zusammensetzung gemäss Anspruch 3, worin in der Formel (IIh) R₁ für Wasserstoff und R₂ für Methyl steht.

5. Zusammensetzung gemäss Anspruch 2, worin in der Formel (IIh) Y für C₁-C₂₀-Alkylen, R₁ für Wasserstoff und R₂ für Methyl steht.

6. Zusammensetzung gemäss Anspruch 1, enthaltend als Komponente (a) einen Polyester der Formel (I), worin Z für 1,4-Cyclohexylen steht.

7. Zusammensetzung gemäss Anspruch 1, enthaltend als Komponente (a) einen Polyester der Formel (I), worin Z für den zweiwertigen Rest des 1,4-Dihydroxy-1,2,3,4-tetrahydronaphthalins nach dem Entfernen der Hydroxygruppen steht.

8. Zusammensetzung gemäss Anspruch 1, enthaltend als Komponente (b) ein Iodonium-, Sulfonium- oder Sulfoxoniumsalz.

9. Zusammensetzung gemäss Anspruch 1, enthaltend als Komponente (b) Triphenylsulfoniumtriflat oder Triphenylsulfoniumhexafluoroantimonat.

10. Zusammensetzung gemäss Anspruch 1, enthaltend, bezogen auf die Gesamtmenge der Komponenten (a) und (b), 85-99 Gew.-% der Komponente (a) und 1-15 Gew.-% der Komponente (b).

11. Zusammensetzung gemäss Anspruch 10, enthaltend, bezogen auf die Gesamtmenge der Komponenten (a) und (b), 92-98 Gew.-% der Komponente (a) und 2-8 Gew.-% der Komponente (b).

12. Verwendung der Zusammensetzungen gemäss Anspruch 1 als Photoresist zur Herstellung von integrierten Schaltkreisen.

13. Die unter Verwendung der Zusammensetzung gemäss Anspruch 1 hergestellten Druckformen, gedruckten Schaltungen, integrierten Schaltkreise oder silberlosen photographischen Filme.
